# EUROPÄISCHE PATENTSCHRIFT

(11) **EP 1 489 743 B1**
(45) Veröffentlichungstag und Bekanntmachung des Hinweises auf die Patenterteilung: **14.03.2018**
(21) Anmeldenummer: 04011297.1
(22) Anmeldetag: 12.05.2004
(51) Int. Cl.: H03K 17/0814

(54) **Direkte Umkommutierung zwischen Leistungsbauteilen**
Direct switching between power components
Commutation directe entre composants de puissance

(30) Priorität: 23.05.2003 DE 10323445
(43) Veröffentlichungstag der Anmeldung: 22.12.2004
(73) Patentinhaber: Seuffer GmbH & Co. KG, 75365 Calw (DE)
(72) Erfinder: Bass, Wolfgang, 74626 Bretzfeld-Adolzfurt (DE); Kurz, Martin, 71543 Wüstenrot (DE)
(74) Vertreter: Winter, Brandl, Fürniss, Hübner, Röss, Kaiser, Polte - Partnerschaft mbB

(56) Entgegenhaltungen:
- WO-A-2004/003944
- DE-A1- 10 050 287
- US-A- 5 420 532
- US-A- 5 508 906
- US-A- 5 541 806
- US-A- 6 150 854

## Beschreibung

Die Erfindung betrifft eine getaktete Gleichstrom-Steuerschaltung und ein Steuerverfahren zum Umkommutieren eines Stromflusses zwischen zwei gesteuerten Leistungsbauteilen, wobei eines der beiden als Schaltelement und das andere als Freilaufelement geschaltet ist.

Zum Ein- und Ausschalten eines Gleichstroms ist üblicherweise eine Reihenschaltung aus einer Spannungsquelle, einem Halbleiterschalter und einem Verbraucher bzw. einer Last vorgesehen. Bei induktivitätsbehafteten Verbrauchern wird häufig eine Freilaufdiode parallel zum induktivitätsbehafteten Teil des Stromkreises geschaltet, wobei die Induktivität auch beispielsweise durch die Leitung des Stromkreises hervorgerufen oder mithervorgerufen sein kann.

Als Halbleiterschalter wird beispielsweise ein MOSFET (Metal-Oxide-Semiconductor-Feldeffekttransistor) verwendet, der mit Hilfe der Gate-Source-Spannung gesteuert werden kann. Solange der Halbleiterschalter leitet, liegt am Verbindungspunkt zwischen dem Halbleiterschalter und dem Verbraucher, und somit auch an der Freilaufdiode, im Wesentlichen das Versorgungspotential an. Wird nun der Halbleiterschalter durch seine Steuerspannung in den sperrenden Zustand versetzt, so steigt sein Innenwiderstand und die in ihm in Wärme umgewandelte Leistung wird immer größer, da die den Strom aufrechterhaltende Wirkung der Induktivität im Laststromkreis nur geringfügig abnimmt. Es ist daher erforderlich, den Stormfluss durch die Freilaufdiode zu übernehmen, bevor die im Transistor entstehende Wärme zu dessen Beschädigung führt.

Beim Einschalten des Stromes tritt dagegen eine andere Problematik auf, nämlich die Gefahr eines Kurzschlusses. Wurde der Halbleiterspeicher erst kurz vor dem Wiedereinschalten ausgeschaltet, so fließt noch Storm im Laststromkreis, und zwar über die Freilaufdiode. Sinkt dann der Widerstand des Halbleiterschalters aufgrund des Einschaltvorgangs, so wird das Potential am Verbindungspunkt zwischen Halbleiterschalter und Freilaufdiode positiv, so dass die Diode sperrt. Dieses Sperren erfolgt jedoch nicht schlagartig und führt zu der Problematik, dass der Leistungshalbleiter bereits vollständig leitet, während die Freilaufdiode noch nicht vollständig gesperrt ist. Somit besteht die Gefahr eines Kurzschlusses und einer entsprechenden Beschädigung des Leistungshalbleiters und/oder der Diode.

In der Druckschrift EP 0 756 782 B1 ist eine Gleichstrom-Steuerschaltung offenbart zum Ein- und/oder Ausschalten des Stroms bei geringer Verlustleistung und gleichzeitig schnellen Schaltvorgängen, wobei Störspannungen und Störimpulse weitestgehend vermieden werden. Im einzelnen wird vorgeschlagen, den Ein- und Ausschaltstrom eines MOSFET von einem anfänglich erhöhten Wert in Abhängigkeit von der an einer Freilaufdiode abfallenden Spannung kontinuierlich zu verringern, insbesondere proportional zu verringern. Diese Stromverringerung kann auch in Abhängigkeit eines anderen Parameters erfolgen, der von dieser Spannung abhängig ist oder der sich entsprechend dieser Spannung verändert. Überschreitet die Steuerspannung des Schalttransistors dessen Einsatz- oder Schwellenspannung, so fließt ein zunehmender Strom über dessen Laststrecke, wodurch sich der Strom durch die Freilaufdiode entsprechend verringert. Die Flussspannung der Freilaufdiode wird dadurch kleiner. Entsprechend der Verringerung der Flussspannung der Freilaufdiode verringert sich auch der über Hilfsspannungsquellen erzeugte Steuerstrom des Schalttransistors. Der festeingestellte Minimalsteuerstrom ist so gewählt, dass der Freilaufdiode die notwendige Umschaltzeit zur Verfügung steht. Die Schaltzeiten werden durch die beschriebene Anordnung also so eingestellt, dass die unerwünschten Effekte praktisch nicht mehr entstehen und die elektromagnetische Verträglichkeit sichergestellt ist.

Bei dem vorgenannten bekannten Kommutierungsverfahren ist allerdings nachteilig, dass inzwischen die Kosten eines MOSFETs geringer sein können, als die der Dioden. Darüber hinaus können die Durchlassverluste bei MOSFETs über die Größe des Einschaltwiderstands beliebig klein gewählt werden. Bei Dioden ist dies aufgrund der Halbleitercharakteristik nur bedingt möglich. Die Verwendung von MOSFETs als Freilaufelemente ist bereits in Brückenschaltungen bekannt, die beispielsweise als Dreifachschaltung zur Steuerung von elektrisch kommutierten Motoren eingesetzt werden. Bei solchen Schaltungen ist allerdings nachteilig, dass als Freilaufelement die inhärente Körperdiode des MOSFET verwendet wird. Diese Diode hat wesentlich schlechtere Eigenschaften als beispielsweise eine übliche Metall-Halbleiter-Diode, wie beispielsweise eine Schottky-Diode. Daher wird oft zusätzlich eine Schottky-Diode parallel geschaltet, wodurch Zusatzkosten verursacht werden. Zur Verminderung der Verluste kann der Freilauf-MOSFET während der Freilaufphase eingeschaltet werden, um die Verluste zu minimieren. Diese Technik ist als Synchron-Gleichrichtung bekannt.

In der vorstehend beschriebenen Druckschrift EP 0 756 782 B1 wird auch erwähnt, dass an Stelle der Freilaufdiode auch eine beliebiges anderes Freilauf-Halbleiterbauteil, wie beispielsweise ein unipolarer Transistor, verwendet werden kann. Dabei wird weiterhin lediglich der Schalttransistor so geregelt, dass dem Freilauf-Halbleiterbauteil die notwendige Schaltzeit zur Verfügung gestellt wird.

Des Weiteren offenbart die Druckschrift DE 100 50 287 A1 eine verpolsichere Schutzeinrichtung für die Ansteuerung eines getakteten elektromagnetischen Verbrauchers, wobei die Schutzeinrichtung einen Leistungstransistor aufweist, mittels dessen die dem elektromagnetischen Verbraucher zuzuführende elektrische Leistung eingeschaltet und gesteuert werden kann. Der Betrieb eines elektromagnetischen (induktiven) Verbrauchers erfordert, dass beim Abschalten ein Freilaufelement in Form eines Freilauf-Transistors vorgesehen ist, über den während des Abschaltvorgangs der in dem elektromagnetischen Verbraucher induzierte Strom abgeleitet wird. Der Freilauf-Transistor ist anstelle einer Leistungsdiode vorgesehen und wirkt in der Schaltungsanordnung als reine Diode. Die Kommutierung erfolgt hierbei kurz vor einem Umschalten über die Diode. Die Schaltungsanordnung umfasst ferner eine Verpolschutzeinrichtung, wobei Bauelemente des Freilauf-Transistors und der Verpolschutzeinrichtung in einem Gehäuse zusammen angeordnet werden können.

Die Druckschrift US 6 150 854 offenbart eine Schaltungsanordnung zum Schalten von induktiven Lasten, wobei ein Leistungstransistor vorgesehen ist zum Schalten einer Versorgungsspannung zu der induktiven Last für den Betrieb derselben, und wobei ferner ein Freilauftransistor vorgesehen ist, der beim Abschalten des Leistungstransistors dem Ableiten des in der induktiven Last beim Abschalten induzierten Stroms dient. Da der Leistungstransistor und der Freilauftransistor zueinander in Reihe angeordnet sind, besteht die Möglichkeit, dass bei gleichzeitigem Öffnen der Transistoren die Spannungsquelle kurz geschlossen wird, sodass sicher gestellt ist, dass beide Transistoren lediglich alternierend zueinander geöffnet werden.

Die Druckschrift US 5 541 806 offenbart eine Schaltungsanordnung zum Steuern der Leistungszufuhr zu einem induktiven Verbraucher, wobei Ströme während des Betriebs des induktiven Verbrauchers gemessen werden. Insbesondere erfolgt eine Messung des Stroms bei der Leistungszufuhr zu dem induktiven Verbraucher, in dem der Strom durch einen Leistungstransistor zur Steuerung der Leistungszufuhr gemessen wird. Des Weiteren erfolgt eine Messung des Stroms durch einen Freilauftransistor, wenn nach dem Abschalten des Leistungstransistors und Beenden der Leistungszufuhr zu dem induktiven Verbraucher ein induzierter Strom in dem induktiven Verbraucher über den Freilauftransistor abgeleitet wird. Hierzu sind jeweils mit dem Leistungstransistor und dem Freilauftransistor Stromerfassungswiderstände in Reihe geschaltet. Das Ein- und Ausschalten der Transistoren erfolgt im Sinne einer zeitlichen Steuerung ohne Überlappung.

Die Druckschrift US 5 508 906 offenbart eine Ansteuerungsschaltung für vorzugsweise einen induktiven Verbraucher, wobei neben einem Leistungstransistor zum Steuern der Leistungszufuhr zu dem Verbraucher ebenfalls ein Freilauftransistor vorgesehen ist. Die Schaltungsanordnung ermöglicht auch die Rückspeisung von in dem induktiven Verbraucher gespeicherter Energie, wobei die Rückspeisung über ein einzuschaltendes Schaltelement dann vorgenommen wird, wenn der Leistungstransistor für die Leistungszufuhr zu dem induktiven Verbraucher bereits abgeschaltet ist.

Die Druckschrift US 5 524 532 offenbart eine synchrone Gleichrichterschaltung, zum wirksamen Ausschalten von angeschlossenen induktiven Verbrauchern. Ein Leistungsschalter zur Versorgung eines induktiven Verbrauchers wird zuerst abgeschaltet, worauf Betriebsbedingungen während des Abschaltens überwacht werden. Sodann wird eine Steuerschaltung in Abhängigkeit von einer dem induktiven Verbraucher induzierten Spannung aktiviert und eingeschaltet, wobei die in dem induktiven Verbraucher gespeicherte Energie zumindest teilweise zurückgeführt werden kann. Während der Leistungsrückführung erfolgt die Festlegung der Ausgangsspannung auf einen vorbestimmten Bereich, wobei der Leistungsumsatz innerhalb der Schaltung während des Abschaltens einer induktiven Last vermindert werden kann.

Es ist Aufgabe der vorliegenden Erfindung, eine getaktete Gleichstrom-Steuerschaltung und ein Umkommutierungsverfahren bereitzustellen, durch die die Verluste und Störaussendungen weiter verringert werden können.

Diese Aufgabe wird gelöst durch eine getaktete Gleichstrom-Steuerschaltung nach Patentanspruch 1 und ein Umkommutierungsverfahren nach Patentanspruch 26.

Erfindungsgemäß wird das Freilaufelement so geregelt, dass es während des Umkommutierens und Schaltens im eingeschalteten Zustand gehalten wird. Damit kann erreicht werden, dass sowohl das Schaltelement als auch das Freilaufelement genau den Strom führen, der durch parasitäre Induktivitäten und Bauteilgrenzen zulässig ist, ohne induktive Spannungs- oder Stromspitzen zu erzeugen. Beide Schaltelemente können somit optimal aufeinander abgestimmt geschaltet werden. Zunächst wird durch die Verwendung des gesteuerten Freilaufelements erreicht, dass nicht die relativ langsame und störkritische Freilaufdiode die Umkommutierung bestimmt, sondern ein beliebig schnell stellbares Leistungsbauteil als Freilaufelement. Durch die aktive Ansteuerung des Freilaufelements können die Verluste minimiert werden, ohne zusätzliche Störaussendungen zu erzeugen. Dadurch ist eine Verringerung der Verluste auf ein Drittel bei besserer Störaussendung erreichbar. Sowohl Kühlaufwand als auch Entstörmaßnahmen können somit reduziert werden. Auch eine zusätzliche Schottky-Diode ist nicht erforderlich.

Die Ansteuerung der Freilaufsteuerschaltung kann im Ansprechen auf einen beliebigen, an einem der Leistungsbauteile erfassbaren Parameter erfolgen. So kann es sich bei dem Parameter beispielsweise um eine den Strom eines der Leistungsbauteile entsprechende Größe handeln. Ferner kann eine der Spannung über einem der Leistungsbauteile entsprechende Größe als Parameter gewählt werden. Schließlich kann es sich auch um eine der Ansteuerspannung des Elements entsprechende Größe handeln. Der Parameter kann aber auch eine aus zumindest einer der vorgenannten Größen abgeleitete Größe sein.

Während des Umkommutierens kann das Freilaufelement geregelt und das Schaltelement gestellt sein. Als Alternative kann auch das Schaltelement während des Umkommutierens geregelt und das Freilaufelement gestellt sein. Ferner kann die Steuerschaltung ausgestaltet sein zum Wechseln der Regel- und Stellfunktionen zwischen dem Freilaufelement und dem Schaltelement im Ansprechen auf zumindest eine vorbestimmte Schaltflanke. Dabei kann die Freilaufsteuerschaltung ausgestaltet sein zur Regelung der Spannung über dem Freilaufelement auf einen die Sättigungsspannung des Freilaufelements geringfügig überschreitenden Wert.

Es wird darauf hingewiesen, dass im Zusammenhang mit der vorliegenden Erfindung die Begriffe "Regeln", "Steuern" und "Stellen" wie folgt zu interpretieren sind. Unter dem Begriff "Regeln" soll ein Vorgang verstanden werden, bei dem eine zu regelnde Größe, z.B. der an einem der Leistungsbauteile erfassbare Parameter, erfasst und abhängig von einem Vergleich mit einer Führungsgröße, z.B. einem vorbestimmten Schwellwert, im Sinne einer Angleichung an die Führungsgröße beeinflusst wird. Dagegen soll unter dem Begriff "Stellen" ein Vorgang verstanden werden, bei dem eine oder mehrere Größen als Eingangsgrößen andere Größen als Ausgangsgrößen auf Grund einer dem System eigentümlichen Gesetzmäßigkeit beeinflussen. Kennzeichnend für das "Stellen" ist somit der offene Wirkungsablauf im Gegensatz zum geschlossenen Regelkreis. Der Begriff "Steuern" wird dagegen als allgemeiner Oberbegriff für die beiden Begriffe "Regeln" und "Stellen" verwendet.

Die Freilaufsteuerschaltung kann auch ausgestaltet sein zur Änderung der Spannung über dem Freilaufelement im Ansprechen auf die vorherrschende Temperatur. Auch kann die Freilaufsteuerschaltung ausgestaltet sein zur Änderung der Spannung über dem Freilaufelement im Ansprechen auf den zu kommutierenden Laststrom.

Des Weiteren kann eine Schaltsteuerschaltung vorgesehen sein zum Ansteuern des Schaltelements im Ansprechen auf die Spannung über dem Freilaufelement. Die Schaltsteuerschaltung kann insbesondere ausgestaltet sein zur Steuerung der Geschwindigkeit der Ansteuerung des Schaltelements im Ansprechen auf die Spannungshöhe über dem Freilaufelement. Dabei kann die Geschwindigkeit bei kleiner Spannungshöhe klein und bei großer Spannungshöhe groß gewählt sein. Die Ansteuerung durch die Schaltsteuerschaltung kann stufenweise oder stetig erfolgen.

Die Freilaufsteuerschaltung kann ferner ausgestaltet sein zum vollständigen Durchschalten des Freilaufelements während der Freilaufzeit. Insbesondere kann die Freilaufsteuerschaltung ausgestaltet sein zur Wiederaufnahme der Regelung des Freilaufelements vor dem Einschalten des Schaltelements.

Die Umkommutierung kann durch einen Ansteuerparameter des Schaltelements erfolgen.

Das Einschalten des Freilaufelements durch die Freilaufsteuerschaltung kann während des vollständig durchgeschalteten Zustands des Schaltelements gesperrt sein.

Die Leistungsbauteile können durch MOSFETs gebildet sein. In diesem Fall kann die Gate-Spannung als Ansteuerparameter dienen. Ferner kann die Ansteuergeschwindigkeit über die Höhe des Gate-Stroms gewählt sein.

Die Erfindung wird im Folgenden anhand eines Ausführungsbeispiel unter Bezugnahme auf die Zeichnungsfiguren näher erläutert.

Es zeigen:
- Fig. 1: ein prinzipielles Blockschaltbild einer Gleichstrom-Steuerschaltung nach dem bevorzugten Ausführungsbeispiel; und
- Fig. 2: verschiedene Zeitdiagramme charakteristischer Größen des Ausführungsbeispiels.

Es folgt eine nähere Beschreibung des bevorzugten Ausführungsbeispiels einer getakteten Gleichstrom-Steuerschaltung mit MOSFETs als schaltendes Leistungsbauteil und als Freilauf-Leistungsbauteil.

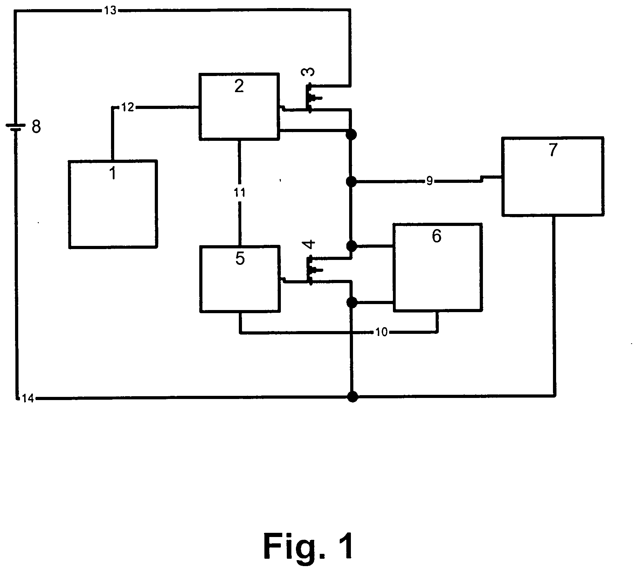

Fig. 1 zeigt ein prinzipielles Blockschaltbild der getakteten Gleichstrom-Steuerschaltung als Stromversorgung beispielsweise in einem Kraftfahrzeug. Die Vorgabe zur Umschaltung eines Schalt-MOSFETs 3 erfolgt hier beispielsweise durch eine übergeordnete Steuereinheit 1. Diese kann beispielsweise durch einen Mikrokontroller oder eine Pulsweitenmodulationsschaltung gebildet sein. Durch diese Schaltvorgabe wird eine Ansteuerschaltung 2 des Schalt-MOSFETs 3 zum Einschalten des Schalt-MOSFETs 3 gesteuert und es fließt ein Laststrom von einer Spannungsversorgung 8 über eine positive Versorgungsleitung 13, den Schalt-MOSFET 3, einen Ausgangsanschluss 9, eine Last 7 und eine negative Versorgungsleitung 14 zurück zur Spannungsversorgung 8. Dabei liegt über einem Freilauf-MOSFET 4 eine positive Spannung zwischen dem Ausgangsanschluss 9 und der negativen Versorgungsleitung 14. Eine Regelschaltung 6 des Freilauf-MOSFETs 4 erfasst die positive Spannung am Freilauf-MOSFET 4 und schaltet den Freilauf-MOSFET 4 aus. Darüber hinaus kann der Freiauf-MOSFET 4 in diesem Zustand gegen ein Einschalten verriegelt werden. Dies kann beispielweise durch eine Ansteuerschaltung 5 des Freilauf-MOSFETs im Ansprechen auf ein Ansteuersignal 11 der Ansteuerschaltung 2 des Schalt.-MOSFETs 3 oder direkt durch ein Signal der übergeordneten Steuereinheit 1 erfolgen.

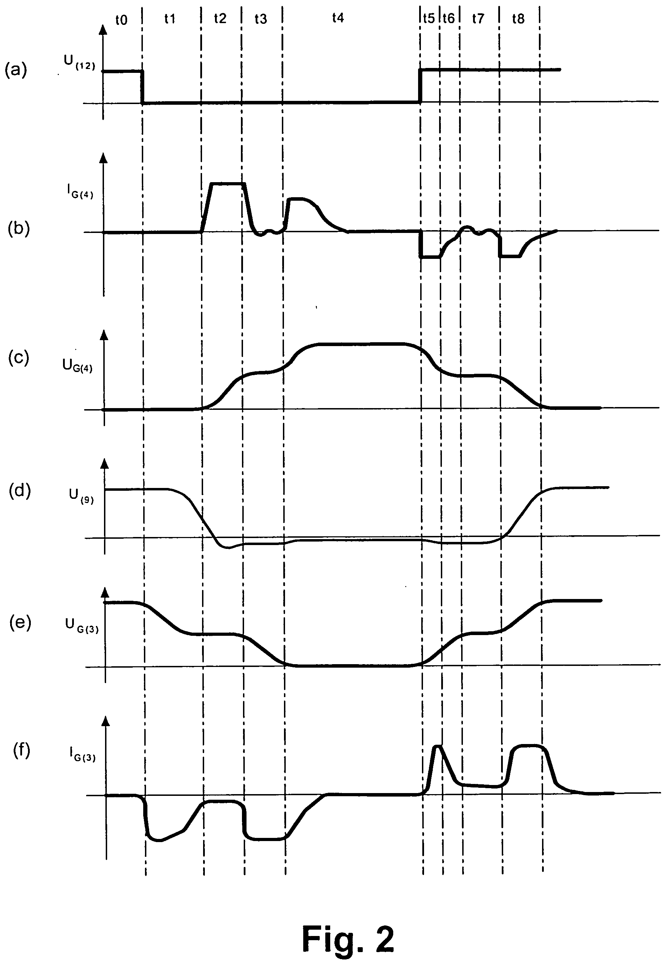

Im Folgenden wird die Funktionsweise der in Fig. 1 gezeigten Schaltung anhand von Zeitdiagrammen (a) bis (f) verschiedener Transistorgrößen oder -parametern gemäß Fig. 2 näher erläutert. Im Einzelnen sind in Fig. 2 dargestellt ein Zeitdiagramm (a) der Spannung U₍₁₂₎ des Vorgabeschaltsignals 12 der übergeordneten Steuereinheit 1, ein Zeitdiagramm (b) des Gate-Steuerstroms I_{G(4)} des Freilauf-MOSFETs 4, ein Zeitdiagramm (c) der Gate-Spannung U_{G(4)} des Freilauf-MOSFETs 4, ein Zeitdiagramm (d) der Ausgangsspannung U₍₉₎ am Ausgangsanschluss 9, ein Zeitdiagramm (e) der Gate-Spannung U_{G(3)} des Schalt-MOSFETs 3 und ein Zeitdiagramm (f) des Gate-Stroms I_{G(3)} des Schalt-MOSFETs 3.

Die Funktionsbeschreibung erfolgt unter Bezugnahme auf die in Fig. 2 angegebenen Zeitperioden t0 bis t8. Dabei kennzeichnet die Zeitperiode t0 die Zeit vor einem Ausschaltvorgang, die Zeitperiode t1 den Anfang des Ausschaltvorgangs, die Zeitperiode t2 die Stromumkommutierung vom Schalt-MOSFET 3 auf den Freilauf-MOSFET 4, die Zeitperiode t3 das vollständige Ausschalten und Regeln des Freilauf-MOSFETs 4, die Zeitperiode t4 das vollständige Durchschalten des Freilauf-MOSFETs 4, die Zeitperiode t5 das Regeln des Freilauf-MOSFETs 4, die Zeitperiode t6 den Anfangsvorgang des Einschaltens, die Zeitperiode t7 die Stromumkommutierung von dem Freilauf-MOSFET 4 auf den Schalt-MOSFET 3, und die Zeitperiode t8 das vollständige Einschalten des Schalt-MOSFETs 3.

Soll der Schalt-MOSFET 3 nach der Zeitperiode t0 ausgeschaltet werden, so wird das Vorgabe-Schaltsignal 12 zu Beginn der Zeitperiode t1 auf Null gesetzt und dem Schalt-MOSFET 3 wird durch die Ansteuerschaltung 2 Gate-Ladung entzogen, d.h. es fließt ein negativer Gatestrom I_{G(3)}. Dies erfolgt gemäß den Zeitdiagrammen (e) und (f) in Fig. 2 während der Zeitperiode t1 vorzugsweise anfangs sehr schnell. Wird dann der Freilauf-MOSFET 4 in der Zeitperiode t2 über die Regelschaltung 6 und dessen Ansteuerschaltung 5 im Ansprechen auf die Ausgangsspannung am Ausgangsanschluss 9 nach Unterschreiten eines vorgegebenen Schwellwerts aktiviert bzw. eingeschaltet, so verlangsamt sich der Ausschaltvorgang des Schalt-MOSFETs 3 gegenüber dem des Freilauf-MOSFETs 4. dieses Einschalten wird im Zeitdiagramm (b) durch den positiven Gatestrom I_{G(4)} erkennbar. Ist der Freilauf-MOSFET 4 in der Zeitperiode t3 voll durchgeschaltet, d.h. die Sättigungsspannung ist höher als die durch den Laststrom verursachte Spannung, bzw. der Storm durch den Freilauf-MOSFET 4 ist höher als der Laststrom, so kann der Schalt-MOSFET 3 durch dessen Ansteuerschaltung 2 schnell abgeschaltet werden, um Querströme zu vermeiden. Dieses schnelle Abschalten wird im Zeitdiagramm (f) durch eine zweite Phase eines negativen Gatestroms I_{G(3)} erkennbar. Die Ansteuerung des Schalt-MOSFETs 3 kann durch langsames Schalten von Anfang an, durch stufenweises Schalten oder durch gesteuerte Strom- oder Spannungsquellen abhängig von der Ausgangsspannung U₍₉₎ oder dem Schaltzustand des Freilauf-MOSFETs 4, beispielsweise dessen GATE-Spannung U_{G(4)}, erfolgen. Dieser Vorgang entspricht einer Steuerung des Schalt-MOSFETs 3.

Gemäß Zeitdiagramm (d) in Fig. 2 sinkt die Ausgangsspannung U₍₉₎ während dieses Vorgangs ab. Der Strom durch die Last 7 wird allerdings durch die induktiven Lastanteile konstant gehalten, so dass eine negative Spannung über dem Freilauf-MOSFET 4 entsteht. Ab einer vorgegebenen negativen Schwellspannung regelt die Regelspannung 6 diese Spannung auf einen eingestellten vorgegebenen Spannungswert, indem sie den Freilauf-MOSFET 4 mittels dessen Ansteuerschaltung 5 so ansteuert, dass die Spannung über dem Freilauf-MOSFET 4 auf einen Wert etwas oder geringfügig größer als der Wert der Sättigungsspannung des Freilauf-MOSFETs 4 geregelt wird. Sinkt die Ausgangsspannung U₍₉₎ weiter, so wird der Freilauf-MOSFET 4 weiter aufgesteuert und die Ausgangsspannung U₍₉₎ steigt wieder und umgekehrt. Diese Regelung der Spannung über dem Freilauf-MOSFET 4 kann zudem in Abhängigkeit der Temperatur und/oder des Laststrom gesteuert sein. Dabei sind dann entsprechende Sensor- oder Erfassungselemente für die Regelschaltung 6 vorgesehen.

Die Regelung der Regelungsschaltung 6 des Freilauf-MOSFETs 4 kann bei positiven Spannungen abgeschaltet werden und wirkt dann als Gleichrichtung.

Ist der Schalt-MOSFET 3 vollkommen ausgeschaltet, so kann der Freilauf-MOSFET 4 vollkommen durchgeschaltet werden, um die Verlustleistung zu minimieren. In Fig. 2 geschieht dies während der Zeitperiode t4 und ist als positiver Impuls des Gatestroms I_{G(4)} im Zeitdiagramm (b) erkennbar. Insbesondere kann dies beispielsweise dadurch erreicht werden, dass der Sollwert der Regelung des Freilauf-MOSFETs 4 durch die Regelschaltung 6 auf einen geringeren Wert, beispielsweise ungefähr 0V, geregelt wird. Als Alternative könnte eine entsprechende Steuerung durch die übergeordnete Steuereinheit 1 erfolgen.

Soll nun der Schalt-MOSFET 3 zu Beginn der Zeitperiode t5 wieder eingeschaltet werden, so wird das Vorgabe-Schaltsignal 12 durch die übergeordnete Steuereinheit 1 auf eine hohe Spannung U₍₁₂₎ umgeschaltet, und die vorgenannte Prozedur beginnt im Wesentlichen in umgekehrter Reihenfolge. Zunächst wird der Gate-Strom des Schalt-MOSFETs 3 gemäß Zeitdiagramm (f) in Fig. 2 erhöht und der Gate-Strom I_{G(4)} des Freilauf-MOSFETs 4 gemäß Zeitdiagramm (b) in Fig. 2 auf einen negativen Wert gesetzt. Die Regelschaltung 6 des Freilauf-MOSFETs 4 wird dann während der Zeitperiode t6 in Abhängigkeit der Spannung U₍₉₎ am Ausgangsanschluss 9 in den Regelbetrieb gebracht, wobei der Sollwert auf einen negativeren Wert als die Sättigungsspannung des Freilauf-MOSFETs 4 gesetzt wird. Das Gate des Schalt-MOSFETs 3 kann dann durch dessen Ansteuerschaltung 2 während der Dauer des leitenden Zustands des Freilauf-MOSFETs 4 schnell mit Ladung gefüllt werden, bis der Schalt-MOSFET 3 zu leiten beginnt. Dadurch wird ein Teil des durch den Freilauf-MOSFET 4 fließenden Stroms übernommen, wobei aber die Regelschaltung 6 den Freilauf-MOSFET 4 aufgrund der zunehmenden Ausgangsspannung U₍₉₎ immer weniger ansteuert (negativer Gatestrom I_{G(4)}), bis dieser schließlich während der Zeitperiode t7 vollständig ausgeschaltet ist. Dabei sollte der Schalt-MOSFET 3 nicht schneller eingeschaltet werden als der Freilauf-MOSFET 4 durch die Regelschaltung 6 abgeschaltet werden kann. Ist der Freilauf-MOSFET 4 vollständig abgeschaltet, so steigt die Ausgangsspannung U₍₉₎ auf einen positiven Wert und der Schalt-MOSFET 3 kann während der Zeitperiode t8 nun schnell eingeschaltet werden, um die Verluste wiederum zu minimieren. Dieses schnelle Einschalten ist im Zeitdiagramm (f) durch den zweiten positiven Stromimpuls erkennbar.

Wie aus den Zeitdiagrammen (b) und (c) in Fig. 2 erkennbar ist, wird der Freilauf-MOSFET 4 während des jeweiligen Umkommutierungsvorgangs so geregelt, dass er im eingeschalteten Zustand gehalten wird. Alternativ dazu kann auch der Schalt-MOSFET 3 zum Regeln des betreffenden Parameters, wie bspw. der Freilaufspannung, des Freilauf-MOSFETs 4 angesteuert sein. Dabei kann dann der Freilauf-MOSFET 4 gestellt sein. Auch ist ein Wechsel der Funktionen während des Betriebs denkbar. So kann bspw. der Schalt-MOSFET 3 bei steigender Flanke des Vorgabeschaltsignals 12 geregelt sein, während der Freilauf-MOSFET 4 dann bei fallender Flanke geregelt ist. Selbstverständlich ist auch der umgekehrte Fall möglich. Die Regel- und Stellfunktionen können somit zwischen dem Schalt-MOSFET 3 und dem Freilauf-MOSFET 4 in beliebiger Weise an jeder oder zumindest einer vorbestimmten Schaltflanke getauscht werden.

Selbstverständlich können die Funktionen der in Fig. 1 gezeigten MOSFETs auch vertauscht sein, so dass der obere MOSFET 3 als Freilauf-Bauteil geschaltet sein kann. Des Weiteren könne auch andere Schaltbauteile wie beispielsweise IGBs (Isolated-Gate-Bipolar-Transistor) oder Bipolar-Transistoren an Stelle der MOSFETs verwendet werden.

Die Regel- bzw. Stellvorgaben können aus den Spannungen an den betreffenden Bauteilen, den Strömen durch die betreffenden Bauteile oder davon abgeleitete Größen gewonnen werden. Die Regelung des Freilauf-MOSFETs 4 durch die Regelschaltung 6 kann auch im Ansprechen auf einen anderen, an einem der Leistungsbauteile, d.h. Schalt-MOSFET 3 oder Freilauf-MOSFET 4 erfassbaren, für die Regelung geeigneten Parameter erfolgen.

Bei der Regelschaltung 6 kann es sich um eine gewöhnliche Regelschaltung mit proportionalem, integrierendem, differenzierendem oder kombiniertem Verhalten handeln. Die Ansteuerschaltungen 2, 5 können durch einfache Transistor-Vorverstärkerstufen gebildet sein.

## Patentansprüche

1. Getaktete Gleichstrom-Steuerschaltung zum Umkommutieren eines Stromflusses zwischen zwei gesteuerten Leistungsbauteilen (3, 4), wobei eines der beiden Leistungsbauteile als Schaltelement (3) und das andere als Freilaufelement (4) geschaltet ist,
**gekennzeichnet durch** eine Freilaufsteuerschaltung (5, 6) zum Steuern des Freilaufelement (4) derart, dass bei einem Einschalten des Freilaufelements (4) und Ausschalten des Schaltelements (3) während der Umkommutierung das Freilaufelement (4) im eingeschalteten Zustand gehalten wird, wobei nach dem Einleiten eines Ausschaltvorgangs (t1) des Schaltelements (3) das Einschalten des Freilaufelements (4) eingeleitet (t2) und der Ausschaltvorgang des Schaltelements (3) verzögert wird, und danach das Schaltelement (3) vollständig ausgeschaltet wird, und
wobei das Einschalten des Freilaufelements (4) während einer vorbestimmten Zeitdauer (t3) während des vollständigen Ausschaltens des Schaltelements (3) verzögert wird und danach (t4) vollständig eingeschaltet wird.

2. Steuerschaltung nach Anspruch 1,
**dadurch gekennzeichnet, dass** der Parameter eine dem Strom durch eines der Leistungsbauteile (3, 4) entsprechende Größe ist.

3. Steuerschaltung nach Anspruch 1,
**dadurch gekennzeichnet, dass** der Parameter eine der Spannung über einem der Leistungsbauteile (3, 4) entsprechende Größe ist.

4. Steuerschaltung nach Anspruch 1,
**dadurch gekennzeichnet, dass** der Parameter eine der Ansteuerspannung des Schaltelements (3) entsprechende Größe ist.

5. Steuerschaltung nach Anspruch 1,
**dadurch gekennzeichnet, dass** der Parameter eine dem Ansteuerstrom des Schaltelements (3) entsprechende Größe ist.

6. Steuerschaltung nach Anspruch 1,
**dadurch gekennzeichnet, dass** der Parameter aus zumindest einer der in den Patentansprüchen 2 bis 5 angegebenen Größe abgeleitet ist.

7. Steuerschaltung nach einem der vorgenannten Ansprüche,
**dadurch gekennzeichnet, dass** das Freilaufelement (4) während des Umkommutierens geregelt und das Schaltelement (3) gestellt ist.

8. Steuerschaltung nach einem der Ansprüche 1 bis 6,
**dadurch gekennzeichnet, dass** das Schaltelement (3) während des Umkommutierens geregelt und das Freilaufelement (4) gestellt ist.

9. Steuerschaltung nach einem der Ansprüche 1 bis 6,
**dadurch gekennzeichnet, dass** die Steuerschaltung ausgestaltet ist zum Wechseln der Regel- und Stellfunktionen zwischen dem Freilaufelement (4) und dem Schaltelement (3) im Ansprechen auf zumindest eine vorbestimmte Schaltflanke.

10. Steuerschaltung nach einem der vorgenannten Ansprüche,
**dadurch gekennzeichnet, dass** die Freilaufsteuerschaltung (5, 6) ausgestaltet ist zur Regelung der Spannung über dem Freilaufelement (4) auf einen die Sättigungsspannung des Freilaufelements (4) geringfügig überschreitenden Wert, im Ansprechen auf den Freilaufstrom.

11. Steuerschaltung nach Anspruch 10,
**dadurch gekennzeichnet, dass** die Freilaufsteuerschaltung (5, 6) ausgestaltet ist zur Änderung der Spannung über dem Freilaufelement (4) im Ansprechen auf die vorherrschende Temperatur.

12. Steuerschaltung nach Anspruch 10 oder 11,
**dadurch gekennzeichnet, dass** die Freilaufsteuerschaltung (5, 6) ausgestaltet ist zur Änderung der Spannung über dem Freilaufelement (4) im Ansprechen auf den zu kommutierenden Laststrom.

13. Steuerschaltung nach einem der vorgenannten Ansprüche,
**gekennzeichnet durch** eine Schaltsteuerschaltung (2) zum Ansteuern des Schaltelements (3) im Ansprechen auf die Spannung über dem Freilaufelement (4).

14. Steuerschaltung nach Anspruch 13,
**dadurch gekennzeichnet, dass** die Schaltsteuerschaltung (2) ausgestaltet ist zur Steuerung der Geschwindigkeit der Ansteuerung des Schaltelements (3) im Ansprechen auf die Spannungshöhe über dem Freilaufelement (4).

15. Steuerschaltung nach Anspruch 14,
**dadurch gekennzeichnet, dass** die Geschwindigkeit bei kleiner Spannungshöhe klein ist und bei großer Spannungshöhe groß ist.

16. Steuerschaltung nach einem der Ansprüche 13 bis 15,
**dadurch gekennzeichnet, dass** die Ansteuerung durch die Schaltsteuerschaltung (2) stufenweise erfolgt.

17. Steuerschaltung nach einem der Ansprüche 13 bis 15,
**dadurch gekennzeichnet, dass** die Ansteuerung durch die Schaltsteuerschaltung (2) stetig erfolgt.

18. Steuerschaltung nach einem der vorgenannten Ansprüche,
**dadurch gekennzeichnet, dass** die Freilaufsteuerschaltung (5, 6) ausgestaltet ist zum vollständigen Durchschalten des Freilaufelements (4) während der Freilaufzeit.

19. Steuerschaltung nach Anspruch 18,
**dadurch gekennzeichnet, dass** die Freilaufsteuerschaltung (5, 6) ausgestaltet ist zur Wiederaufnahme der Regelung des Freilaufelements (4) vor dem Einschalten des Schaltelements (3).

20. Steuerschaltung nach einem der vorgenannten Ansprüche,
**dadurch gekennzeichnet, dass** die Umkommutierung durch einen Ansteuerparameter des Schaltelements (3) erfolgt.

21. Steuerschaltung nach einem der vorgenannten Ansprüche,
**dadurch gekennzeichnet, dass** das Einschalten des Freilaufelements (4) durch die Freilaufsteuerschaltung (5, 6) während des vollständig durchgeschalteten Zustands des Schaltelements gesperrt ist.

22. Steuerschaltung nach einem der vorgenannten Ansprüche,
**dadurch gekennzeichnet, dass** die Leistungsbauteile durch MOSFETs (3, 4) gebildet sind.

23. Steuerschaltung nach Anspruch 22,
**dadurch gekennzeichnet, dass** als Ansteuerparameter die GATE-Spannung dient.

24. Steuerschaltung nach Anspruch 22 oder 23,
**dadurch gekennzeichnet, dass** die Ansteuergeschwindigkeit über die Höhe des GATE-Stroms gesteuert ist.

25. Verfahren zum Umkommutieren eines Stromflusses zwischen zwei gesteuerten Leistungsbauteilen (3, 4), wobei eines der beiden Leistungsbauteile als Schaltelement (3) und das andere als Freilaufelement (4) geschaltet ist,
**gekennzeichnet, durch** den Schritt des Steuerns des Freilaufelements (4) derart, dass bei einem Einschalten des Freilaufelements (4) und Ausschalten des Schaltelements (3) während der Umkommutierung das Freilaufelement (4) im eingeschalteten Zustand gehalten wird, wobei nach dem Einleiten eines Ausschaltvorgangs (t1) des Schaltelements (3) das Einschalten des Freilaufelements (4) eingeleitet (t2) und der Ausschaltvorgang des Schaltelements (3) verzögert wird, und danach das Schaltelement (3) vollständig ausgeschaltet wird, und
wobei das Einschalten des Freilaufelements (4) während einer vorbestimmten Zeitdauer (t3) während des vollständigen Ausschaltens des Schaltelements (3) verzögert wird und danach (t4) vollständig eingeschaltet wird.

## Claims

1. Clocked DC control circuit for commutating a current flow between two controlled power components (3, 4), wherein one of the two power components is connected as a switching element (3) and the other one as a free-running element (4),
**characterized by** a free-running control circuit (5,6) for controlling the free-running element (4) in such a way that, when the free-running element (4) is turned on and the switching element (3) is turned off during the commutation, the free-running element (4) is kept in the turned-on state, wherein, after initiating a turning-off operation (t1) of the switching element (3), the turning on of the free-running element (4) is initiated (t2) and the turning-off operation of the switching element (3) is delayed, and then the switching element (3) is completely turned off, and
wherein turning on of the free-running element (4) is delayed during a predetermined period of time (t3) during the complete turning off of the switching element (3) and is then (t4) turned on completely.

2. Control circuit according to claim 1,
**characterized in that**
the parameter is a quantity corresponding to the current running through one of the power components (3, 4).

3. Control circuit according to claim 1,
**characterized in that**
the parameter is a quantity corresponding to the voltage running through one of the power components (3, 4).

4. Control circuit according to claim 1,
**characterized in that**
the parameter is a quantity corresponding to the control voltage of the switching element (3).

5. Control circuit according to claim 1,
**characterized in that**
the parameter is a quantity corresponding to the control current of the switching element (3).

6. Control circuit according to claim 1,
**characterized in that**
the parameter is derived from at least one of the quantities stated in patent claims 2 to 5.

7. Control circuit according to one of the preceding claims,
**characterized in that**
the free-running element (4) is regulated during commutating and the switching element (3) is set.

8. Control circuit according to one of the claims 1 to 6,
**characterized in that**
the switching element (3) is regulated during commutating and the free-running element (4) is set.

9. Control circuit according to one of the claims 1 to 6,
**characterized in that**
the control circuit is designed for changing the regulating and setting functions between the free-running element (4) and the switching element (3) in response to at least one predetermined switching edge.

10. Control circuit according to one of the preceding claims,
**characterized in that**
the free-running control circuit (5, 6) is designed to regulate the voltage over the free-running element (4) to a value which slightly exceeds the saturation voltage of the free-running element (4) in response to the free-running current.

11. Control circuit according to claim 10,
**characterized in that**
the free-running control circuit (5, 6) is designed to change the voltage over the free-running element (4) in response to the prevailing temperatures.

12. Control circuit according to claim 10 or 11,
**characterized in that**
the free-running control circuit (5, 6) is designed to change the voltage over the free-running element (4) in response to the commutating load current.

13. Control circuit according to one of the preceding claims,
**characterized by**
a switching control circuit (2) for driving the switching element (3) in response to the voltage over the free-running element (4).

14. Control circuit according to claim 13,
**characterized in that**
the switching control circuit (2) is designed to control the speed of driving the switching element (3) in response to the level of the voltage over the free-running element (4).

15. Control circuit according to claim 14,
**characterized in that**
the speed is small for a small voltage level and high for a high voltage level.

16. Control circuit according to one of the claims 13 to 15,
**characterized in that**
driving is conducted gradually via the switching control circuit (2).

17. Control circuit according to one of the claims 13 to 15,
**characterized in that**
driving is conducted consistently via the switching control circuit (2).

18. Control circuit according to one of the preceding claims,
**characterized in that**
the free-running control circuit (5, 6) is designed to completely switch through the free-running element (4) during the free-running time.

19. Control circuit according to claim 18,
**characterized in that**
the free-running control circuit (5, 6) is designed to resume regulation of the free-running element (4) before turning on the switching element (3).

20. Control circuit according to one of the preceding claims,
**characterized in that**
the commutating is conducted due to a driving parameter of the switching element (3).

21. Control circuit according to one of the preceding claims,
**characterized in that**
turning on of the free-running element (4) by the free-running control circuit (5, 6) is locked during the state in which the switching element is completely switched through.

22. Control circuit according to one of the preceding claims,
**characterized in that**
the power components are formed by MOSFETs (3, 4).

23. Control circuit according to claim 22,
**characterized in that**
the GATE voltage serves as driving parameter.

24. Control circuit according to claim 22 or 23,
**characterized in that**
the driving speed is controlled by the level of the GATE current.

25. A method of commutating a current flow between two controlled power components (3,4), wherein one of the two power components is connected as a switching element (3) and the other one as free-running element (4),
**characterized by** the step of controlling the free-running element (4) in such a way that, when the free-running element (4) is turned on and the switching element (3) is turned off during the commutation, the free-running element (4) is kept in the turned-on state, wherein after initiating a turning-off operation (t1) of the switching element (3), the turning-on of the free-running element (4) is initiated (t2) and the turning-off operation of the switching element (3) is delayed, and then the switching element (3) is completely turned off, and
wherein turning on of the free-running element (4) is delayed during a predetermined period of time (t3) during the complete turning off of the switching element (3) and is then (t4) turned on completely.

## Revendications

1. Circuit de commande cadencé à courant continu pour le basculement de commutation d'un flux de courant entre deux composants de puissance (3, 4) commandés, l'un des deux composants de puissance étant monté en tant qu'élément de commutation (3) et l'autre en tant que qu'élément de roue libre (4),
**caractérisé par** un circuit de commande de roue libre (5, 6) pour la commande de l'élément de roue libre (4), de telle manière que lorsque l'élément de roue libre (4) est mis sous tension et que l'élément de commutation (3) est mis hors tension pendant le basculement de commutation, l'élément de roue libre (4) est maintenu dans l'état mis sous tension, la mise sous tension de l'élément de roue libre (4) étant déclenchée (t2) après le déclenchement d'une procédure de mise hors tension (t1) de l'élément de commutation (3) et la procédure de mise hors tension de l'élément de commutation (3) étant retardée, et l'élément de commutation (3) étant ensuite entièrement mis hors tension, et
la mise sous tension de l'élément de roue libre (4) étant retardée pendant une période de temps (t3) prédéfinie pendant la mise hors tension intégrale de l'élément de commutation (3) et l'élément de roue libre étant ensuite (t4) entièrement mis sous tension.

2. Circuit de commande selon la revendication 1,
**caractérisé en ce que** le paramètre est une grandeur correspondant au courant traversant l'un des composants de puissance (3, 4).

3. Circuit de commande selon la revendication 1,
**caractérisé en ce que** le paramètre est une grandeur correspondant à la tension sur un des composants de puissance (3, 4).

4. Circuit de commande selon la revendication 1,
**caractérisé en ce que** le paramètre est une grandeur correspondant à la tension de commande de l'élément de commutation (3).

5. Circuit de commande selon la revendication 1,
**caractérisé en ce que** le paramètre est une grandeur correspondant au courant de commande de l'élément de commutation (3).

6. Circuit de commande selon la revendication 1,
**caractérisé en ce que** le paramètre est déduit d'au moins une grandeur indiquée dans les revendications 2 à 5.

7. Circuit de commande selon l'une quelconque des revendications précédentes,
**caractérisé en ce que** l'élément de roue libre (4) est réglé pendant le basculement de commutation et l'élément de commutation (3) est arrêté.

8. Circuit de commande selon l'une quelconque des revendications 1 à 6,
**caractérisé en ce que** l'élément de commutation (3) est réglé pendant le basculement de commutation et l'élément de roue libre (4) est arrêté.

9. Circuit de commande selon l'une quelconque des revendications 1 à 6,
**caractérisé en ce que** le circuit de commande est conçu pour alterner les fonctions de réglage et d'arrêt entre l'élément de roue libre (4) et l'élément de commutation (3) en réponse à au moins un flanc de commutation prédéfini.

10. Circuit de commande selon l'une quelconque des revendications précédentes,
**caractérisé en ce que** le circuit de commande de roue libre (5, 6) est conçu pour réguler la tension sur l'élément de roue libre (4) sur une valeur dépassant légèrement la tension de saturation de l'élément de roue libre (4), en réponse au courant de roue libre.

11. Circuit de commande selon la revendication 10,
**caractérisé en ce que** le circuit de commande de roue libre (5, 6) est conçu pour modifier la tension sur l'élément de roue libre (4) en réponse à la température prédominante.

12. Circuit de commande selon la revendication 10 ou 11,
**caractérisé en ce que** le circuit de commande de roue libre (5, 6) est conçu pour modifier la tension sur l'élément de roue libre (4) en réponse au courant de charge à commuter.

13. Circuit de commande selon l'une quelconque des revendications précédentes,
**caractérisé par** un circuit de commande de commutation (2) pour la commande de l'élément de commutation (3) en réponse à la tension sur l'élément de roue libre (4).

14. Circuit de commande selon la revendication 13,
**caractérisé en ce que** le circuit de commande de commutation (2) est conçu pour commander la vitesse de la commande de l'élément de commutation (3) en réponse au niveau de tension sur l'élément de roue libre (4).

15. Circuit de commande selon la revendication 14,
**caractérisé en ce que** la vitesse est faible lorsque le niveau de tension est faible et élevée lorsque le niveau de tension est élevé.

16. Circuit de commande selon l'une quelconque des revendications 13 à 15,
**caractérisé en ce que** la commande est réalisée graduellement par le circuit de commande de commutation (2).

17. Circuit de commande selon l'une quelconque des revendications 13 à 15,
**caractérisé en ce que** la commande est réalisée en continu par le circuit de commande de commutation (2).

18. Circuit de commande selon l'une quelconque des revendications précédentes,
**caractérisé en ce que** le circuit de commande de roue libre (5, 6) est conçu pour commuter intégralement l'élément de roue libre (4) pendant la durée de roue libre.

19. Circuit de commande selon la revendication 18,
**caractérisé en ce que** le circuit de commande de roue libre (5, 6) est conçu pour reprendre la régulation de l'élément de roue libre (4) avant la mise sous tension de l'élément de commutation (3).

20. Circuit de commande selon l'une quelconque des revendications précédentes,
**caractérisé en ce que** le basculement de commutation est réalisé par un paramètre de commande de l'élément de commutation (3).

21. Circuit de commande selon l'une quelconque des revendications précédentes,
**caractérisé en ce que** la mise sous tension de l'élément de roue libre (4) est bloquée par le circuit de commande de roue libre (5, 6) pendant l'état entièrement commuté de l'élément de commutation.

22. Circuit de commande selon l'une quelconque des revendications précédentes,
**caractérisé en ce que** les composants de puissance sont formés par des transistors à effet de champ à semi-conducteur à oxyde métallique (3, 4).

23. Circuit de commande selon la revendication 22,
**caractérisé en ce que** la tension de grille sert de paramètre de commande.

24. Circuit de commande selon la revendication 22 ou 23,
**caractérisé en ce que** la vitesse de commande est commandée par l'intermédiaire du niveau du courant de grille.

25. Procédé de basculement de commutation d'un flux de courant entre deux composants de puissance (3, 4) commandés, l'un des deux composants de puissance étant monté en tant qu'élément de commutation (3) et l'autre en tant qu'élément de roue libre (4),
**caractérisé par** l'étape de commande de l'élément de roue libre (4), de telle manière que, lorsque l'élément de roue libre (4) est mis sous tension et que l'élément de commutation (3) est mis hors tension pendant le basculement de commutation, l'élément de roue libre (4) est maintenu dans l'état mis sous tension, la mise sous tension de l'élément de roue libre (4) étant déclenchée (t2) après le déclenchement d'une procédure de mise hors tension (t1) de l'élément de commutation (3) et la procédure de mise hors tension de l'élément de commutation (3) étant retardée, et après cela l'élément de commutation (3) étant entièrement mis hors tension, et
la mise sous tension de l'élément de roue libre (4) étant retardée pendant une durée (t3) prédéfinie pendant la mise hors tension intégrale de l'élément de commutation (3) et l'élément de roue libre étant ensuite (t4) entièrement mis sous tension.
